# FASCICULE DE BREVET EUROPEEN

(11) **EP 0 272 977 B1**
(45) Date de publication et mention de la délivrance du brevet: **10.03.1993**
(21) Numéro de dépôt: 87402858.2
(22) Date de dépôt: 15.12.1987
(51) Int. Cl.: G06F 12/14, G11C 8/00, G11C 16/06

(54) **Dispositif de protection d'une mémoire morte effaçable et reprogrammable**
Schutzvorrichtung für einen lösch- und neuprogrammierbaren Festwertspeicher
Protection device for an erasable and reprogrammable ROM

(30) Priorité: 19.12.1986 FR 8617887
(43) Date de publication de la demande: 29.06.1988
(73) Titulaire: SGS-THOMSON MICROELECTRONICS S.A., 75016 Paris (FR)
(72) Inventeur: Farrugia, Augustin, F-75008 Paris (FR)
(74) Mandataire: Schmit, Christian Norbert Marie

(56) Documents cités:
- EP-A- 0 142 983
- FR-A- 2 471 004

## Description

La présente invention concerne les dispositifs de protection d'une mémoire morte effaçable et reprogrammable pour circuits intégrés.

Le premier type de mémoire morte effaçable et reprogrammable est connu sous l'appellation de mémoire EPROM. Il s'agit de mémoire non volatile et dont le contenu peut être effacé par exposition à un rayonnement ultra-violet. Sans effacement volontaire du contenu d'une telle mémoire, il est toujours possible d'écrire par dessus une première programmation, mais cela a généralement pour effet de superposer les deux programmations, soit en définitive de perdre les informations.

Le deuxième type de mémoire morte effaçable et reprogrammable est connu sous l'appellation de mémoire EEPROM. Il s'agit dans ce cas, de mémoires non volatiles dont le contenu peut être effacé électriquement, c'est-à-dire, par application de niveaux de tensions prédéterminés. Dans ce cas également, il est toujours possible de reprogrammer par dessus une première programmation, mais cela a également pour effet de perdre toutes les informations.

Lorsque de telles mémoires ont été programmées, il n'est pas possible sans aller lire leur contenu de savoir si elles ont été effectivement programmées.

Or, pour lire le contenu d'une mémoire, il faut la connecter à un circuit de lecture. Cette opération est fastidieuse mais nécessaire si on ne veut pas prendre le risque, en prenant une mémoire pour la programmer, de superposer deux programmations ce qui conduit par conséquent, à des informations n'ayant plus de sens ou à une perte des premières informations stockées.

Il est classique de protéger des EPROM ou EEPROM mémoires contre toute falsification de leur contenu, en les rendant inutilisables. Pour cela, on procède à une programmation d'un bit témoin dans la mémoire, en fin de programmation de celle-ci. Ainsi, lorsque la mémoire est déprogrammée, volontairement ou involontairement, le bit témoin est aussi déprogrammé. Comme ce bit est témoin est utilisé pour l'adressage en lecture, la lecture de la mémoire est bloquée. La présence du bit témoin empêche donc uniquement l'utilisation de la mémoire lorsque celle-ci a été effacée partiellement ou a été reprogrammée. Une telle protection ne convient pas pour résoudre le problème qui est posé, puisqu'il s'agit d'interdire une reprogrammation non désirée.

Dans l'invention on propose de remédier à ce problème. Le document FR-A-2 471 004 propose un dispositif de protection qui comporte les caractéristiques du préambule de la revendication 1. La présente invention propose un dispositif de protection d'une mémoire morte effaçable et reprogrammable qui comporte toutes les caractéristiques de la revendication 1.

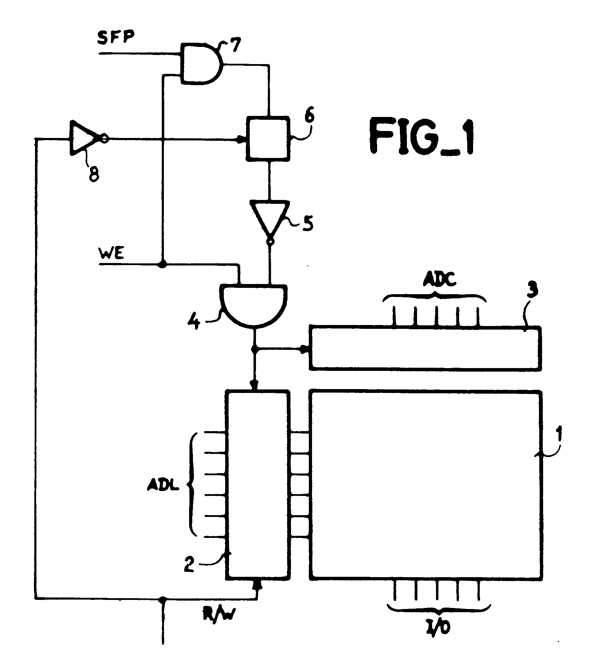

D'autres particularités et avantages de la présente invention apparaîtront clairement à la lecture de la description suivante présentée à titre d'exemple non limitatif et faites en regard de la figure annexée qui représente :
- un schéma de réalisation d'un dispositif selon l'invention correspondant à un mode de réalisation préférentiel.

La mémoire représentée sur la figure unique correspond à une mémoire morte, non volatile, et effaçable soit électriquement, soit par rayonnement ultraviolet.

La programmation de cette mémoire se fait d'une manière classique en soi c'est à dire par application de niveaux de tension déterminés sur chaque ligne et sur chaque colonne de manière à ce que l'état logique de chaque point mémoire formé par un transistor de type MOS relié à une ligne et à une colonne soit modifié ou non.

La programmation de la mémoire est faite par l'intermédiaire de décodeurs de lignes 2 et de colonnes 3. Ces décodeurs permettent respectivement de décoder les adresses lignes ADL et les adresses colonnes ADC et d'aller lire des données O ou écrire des données I selon l'état du signal de lecture-écriture R/W. L'écriture se fait après réception d'un signal d'autorisation WE.

Selon le dispositif de l'invention, le signal d'autorisation d'écriture WE, n'est pas directement appliqué aux décodeurs lignes-colonnes. Ce signal est appliqué à l'entrée d'une porte ET 4. La porte ET 4 reçoit sur une autre entrée le signal de sortie d'une porte inverseuse 5. La porte inverseuse 5 reçoit le signal correspondant à un état logique "0" ou "1" d'une cellule mémoire 6 selon que cette cellule a été programmée ou non. La cellule mémoire 6 est programmée à la réception d'un ordre de fin de programmation SFP de la mémoire 1 et d'autorisation d'écriture WE. Les signaux correspondant SFP et WE sont appliqués respectivement aux entrées d'une porte ET 7. Les deux conditions permettant la programmation de la cellule 6 sont réunies lorsque ces signaux sont à l'état 1 de manière à ce que la sortie de la porte 7 permette, lorsqu'un ordre d'écriture W de la cellule 6 est donné, de programmer cette cellule selon l'état désiré.

Tant que le signal de fin de programmation SFP n'est pas appliqué c'est-à-dire, tant que le signal se trouve à un état 0 la mémoire 1 est programmable. Lorsque l'utilisateur termine la programmation de cette mémoire, il commande l'émission du signal SFP dont l'état logique traduit la fin de programmation et l'état logique du signal d'autorisation d'écriture WE est maintenu de manière à pouvoir écrire dans la cellule 6, ces deux signaux sont reçus à l'entrée de la porte ET 7. Le niveau logique de sortie de cette porte permet alors de programmer la cellule mémoire 6 soit par exemple en la faisant passer d'un état logique 0 à un état logique 1, un ordre d'écriture ayant bien entendu été donné. Pour obtenir l'ordre de lecture-écriture on utilise l'ordre R/W de la mémoire 1, inversé par une porte 8.

Lors d'une première programmation de la mémoire 1, le signal R/W est par exemple à 1, ce qui correspond à un ordre d'écriture pour la mémoire 1, et à un ordre de lecture de la cellule 6. Le signal d'autorisation d'écriture WE est à l'état 1. Le contenu de la cellule 6 est lu, l'état logique de ce contenu est par exemple 0, la sortie de la porte 5 est à 1. La sortie de la porte 4 est à 1, la mémoire 1 est programmable.

A la fin de la programmation de la mémoire 1, le signal SFP est à 1, le signal W est à 1, le signal R/W est à 0 ce qui correspond à un ordre d'écriture de la cellule 6. L'état logique de programmation de la cellule est par exemple un 1. La sortie de la porte 5 est un 0. La porte 4 interdit toute autorisation d'écriture.

Pendant toute tentative d'écriture dans la mémoire 1, après programmation de la cellule 6, le contenu de cette cellule est systématiquement lu, ce qui empêche toute reprogrammation. En effet, la porte ET 4, qui reçoit à l'une de ses entrées le signal traduisant l'état logique de la cellule mémoire 6 interdira, quelque soit l'état logique du signal d'autorisation d'écriture WE dans le mémoire 1, toute reprogrammation de celle-ci. La mémoire 1 est donc protégée contre la reprogrammation c'est-à-dire par un utilisateur qui ne savait pas que cette mémoire était programmée. Il est bien entendu toujours possible de reprogrammer une telle mémoire dans le cas d'une mémoire EPROM par exemple en prévoyant une fenêtre qui laisse passer un rayonnement ultraviolet sur toutes les cellules mémoires y compris la cellule de protection 6 de cette mémoire 1.

Pour permettre la lecture et l'écriture de la cellule 6 qui comporte un transistor à grille flottante, les portes 7 et 8 sont choisies de manière à ce qu'elle fournissent un niveau bas à 5 V ou un niveau haut à 12 V.

## Revendications

1. Dispositif de protection d'une mémoire morte, effaçable et reprogrammable (1), comportant des moyens pour inhiber l'accès à la mémoire, ces moyens comportant une porte logique (4) recevant un premier signal de contrôle correspondant à un état logique "0" ou "1" d'un dispositif de contrôle, et un deuxième signal, cette porte étant elle-même reliée à l'entrée d'un décodeur (2,3) de la mémoire (1), et inhibant la transmission de ce deuxième signal si le signal de contrôle est dans un premier état logique, le dispositif de contrôle recevant un signal de contrôle de lecture/écriture (R/W) de la mémoire, ce deuxième signal et un signal représentant les conditions nécessaires à l'accès de la mémoire, le dispositif de contrôle vérifiant si l'accès à la mémoire est possible, dispositif de protection caractérisé en ce que ce signal représentant les conditions nécessaires est un signal SFP indiquant la fin d'une opération de programmation de la mémoire (1), en ce que ce deuxième signal WE indique un signal d'autorisation d'écriture de la mémoire, en ce que le dispositif de contrôle comporte une cellule mémoire non-volatile (6) fournissant le signal de contrôle, en ce que la cellule est programmée à la réception des signaux correspondants SFP et WE, et en ce que la cellule est tue à chaque fois que l'on veut écrire des données en mémoire (1).

2. Dispositif de protection selon la revendication 1, caractérisé en ce que la porte logique (4) reçoit en entrées la sortie de lecture de la cellule (6) comme signal de contrôle et un signal d'autorisation d'écriture (WE) de la mémoire (1) comme deuxième signal, cette porte logique (4) inhibant la transmission du signal d'autorisation d'écriture de la mémoire (WE) si la cellule est dans le premier état logique.

3. Dispositif de protection selon la revendication 1, caractérisé en ce que le signal de contrôle de lecture/écriture de la cellule (6) est l'inverse du signal de contrôle de lecture/écriture de la mémoire (R/W), en sorte que la cellule (6) est lue à chaque fois que l'on veut écrire des données en mémoire (1).

4. Dispositif de protection selon l'une quelconque des revendications 1 à 3, caractérisé en ce qu'il comporte des moyens pour délivrer le signal de fin de programmation (SFP) à la fin d'une opération d'écriture de la mémoire et qu'une porte logique (7) reçoit en entrées ce signal de fin de programmation (SFP) et le signal d'autorisation d'écriture de la mémoire (WE) et délivre sur réception des ces deux signaux un ordre de programmation de la cellule non-volatile (6).

## Claims

1. A protection device for an erasable and reprogrammable read only memory (1) comprising means for preventing access to the memory, the said means comprising a logic gate (4) which receives a first control signal corresponding to a "0" or "1" logic state of a control device and a second signal, the said gate being itself connected to the input of a decoder (2, 3) of the memory and inhibiting the transmission of the second signal if the control signal is in a first logic state, the control device receiving a memory read/write control signal (R/W), the second signal and a signal representing the conditions necessary for access to the memory, and the control device checking whether access to the memory is possible, the protection device being characterized in that the signal representing the conditions necessary for access is a signal SFP indicating the end of an operation of programming the memory (1) and the second signal WE indicates a signal for enabling writing in the memory, the control device comprises a non-volatile memory cell (6) which supplies the control signal, the cell is programmed on receiving corresponding signals SFP and WE, and the cell is read each time it is desired to write data in the memory (1).

2. A protection device as claimed in claim 1, characterized in that the logic gate (4) receives on its inputs the read output of the cell (6) as the control signal and a write enable signal (WE) for the memory (1) as the second signal, said logic gate (4) inhibiting the transmission of the write enabling signal (WE) for the memory (1) if the cell is in the first logic state.

3. A protection device as claimed in claim 1, characterized in that the read/write signal for controlling the cell (6) is the inverse of the read/write signal (R/W) for controlling the memory so that the cell (6) is read each time it is desired to write data into the memory (1).

4. A protection device as claimed in any one of claims 1 to 3, characterized in that it comprises means for supplying the end of programming signal (SFP) at the end of an operation of writing in the memory and in that a logic gate (7) receives on its inputs the said end of programming signal (SFP) and the write enable signal for the memory (WE) and supplies on receiving these two signals a command for programming the non-volatile cell (6).

## Patentansprüche

1. Schutzvorrichtung für einen lösch- und neuprogrammierbaren Festwertspeicher (1), der Mittel zum Verhindern des Zugriffs auf den Speicher aufweist, welche Mittel ein logisches Gatter (4) aufweisen, das ein erstes Steuersignal, das dem logischen Zustand "0" oder "1" einer Steuervorrichtung entspricht, und ein zweites Signal erhält, wobei dieses Gatter seinerseits mit dem Eingang eines Decodierers (2, 3) für den Speicher (1) verbunden ist und das Übertragen dieses zweiten Signals verhindert, wenn sich das Steuersignal in einem ersten logischen Zustand befindet, wobei die Steuervorrichtung ein Lese/Schreib-Steuersignal (R/W) für den Speicher, das zweite Signal und ein die für den Zugriff auf den Speicher notwendigen Bedingungen repräsentierendes Signal empfängt, wobei die Steuervorrichtung verifiziert, ob der Zugriff auf den Speicher möglich ist, wobei die Schutzvorrichtung **dadurch gekennzeichnet** ist, daß das die notwendigen Bedingungen repräsentierende Signal ein Signal SFP ist, das das Ende eines Programmiervorgangs des Speichers (1) anzeigt, daß das zweite Signal WE ein Schreibfreigabesignal für den Speicher anzeigt, daß die Steuervorrichtung eine nichtflüchtige Speicherzelle (6) aufweist, die das Steuersignal liefert, daß die Zelle bei Empfang der entsprechenden Signale SFB und WE programmiert wird, und daß die Zelle jedes Mal dann gelesen wird, wenn es erwünscht ist, Daten in den Speicher (1) einzuschreiben.

2. Schutzvorrichtung nach Anspruch 1, **dadurch gekennzeichnet,** daß das logische Gatter (4) eingangsseitig das Leseausgangssignal der Zelle (6) als Steuersignal und ein Schreibfreigabesignal (WE) für den Speicher (1) als zweites Signal empfängt, wobei das logische Gatter (4) die Übertragung des Schreibfreigabesignals für den Speicher (WE) sperrt, wenn sich die Zelle in dem ersten logischen Zustand befindet.

3. Schutzvorrichtung nach Anspruch 1, **dadurch gekennzeichnet,** daß das Lese/Schreib-Steuersignal für die Zelle (6) zu dem Lese/Schreib-Steuersignal für den Speicher (R/W) invers ist, damit die Zelle (6) jedesmal dann ausgelesen wird, wenn es erwünscht ist, Daten in den Speicher (1) einzuschreiben.

4. Schutzvorrichtung nach einem der Ansprüche 1 bis 3, **dadurch gekennzeichnet,** daß sie Mittel zum Ausgeben des Programmierendesignals (SFP) am Ende eines Vorgangs zum Einschreiben in den Speicher aufweist, und daß ein logisches Gatter (7) eingangsseitig dieses Programmierendesignal (SFP) und das Schreibfreigabesignal für den Speicher (WE) empfängt und auf den Empfang dieser zwei Signale hin einen Programmierbefehl für die nichtflüchtige Zelle (6) ausgibt.
